# EUROPÄISCHE PATENTANMELDUNG

(11) **EP 1 383 366 A1**
(43) Veröffentlichungstag der Anmeldung: **21.01.2004**
(21) Anmeldenummer: 02405614.5
(22) Anmeldetag: 17.07.2002
(51) Int. Cl.: H05K 3/46

(54) **Verfahren und Vorrichtung zum Fixieren der einzelnen Lagen einer mehrlagigen Leiterplatte**

(71) Anmelder: Printprocess AG, 6300 Zug (CH)
(72) Erfinder: Mauerer, Hartmut, 6312 Steinhausen (CH)
(74) Vertreter: Blum, Rudolf Emil Ernst

(57) **Zusammenfassung**

Beim Stapeln von Innenlagen und Prepregs zur Bildung eines Multilayer-Paketes werden die das Paket bildenden Plättchen (20) in der Layup-Station gegenseitig fixiert. Hierzu wird jede Innenlage zuerst zentriert und danach werden durch Stanzen Zungen (21) so aus der Ebene jeder Innlage (20) herausgebogen, dass alle Zungen (21) ausser derjenigen des untersten Plättchens in die durch ein analoges Stanzen mindestens eines darunterliegenden Plättchen erzeugten Durchbrüche greifen. Dadurch werden die Plättchen (20) gegenseitig verschränkt, wobei sie in den zu den ihren Hauptflächen parallelen Richtungen formschlüssig und in der dazu normalen Richtung kraftschlüssig verbunden sind. Dies gestattet es, das Paket als zusammenhängendes Objekt zu manipulieren und zu lagern ohne die exakte Ausrichtung der Innenlagen (20) parallel zur Hauptebene des Paketes zu gefährden.

## Beschreibung

Die Erfindung betrifft ein Verfahren und eine Vorrichtung zum gegenseitigen Fixieren einzelner Lagen einer Leiterplatte beim Lay-up, um sie bis zu ihrer stabilen Verbindung durch Vernieten, Verschweissen, Verkleben, oder bis zu ihrem endgültigen Verpressen in einer Multilayerpresse in einer bestimmten Relativstellung festzuhalten.

Die elektronische Industrie benötigt grosse Mengen von Leiterplatten die aus sogenannten Multilayer-Paketen bestehen, welche durch Aufeinanderstapeln von meist beidseitig mit Schaltungen bedruckten Platten (sogenannte Innenlagen), unter Zwischenlegen von Isolierfolien (sogenannten Prepregs) hergestellt werden.

Obwohl Innenlagen und Prepregs sehr verschieden beschaffen sind, soll der Übersichtlichkeit halber im Folgenden der Ausdruck "Plättchen" beide Arten von Elementen umfassen. Da gewisse Kontaktstellen verschiedener Innenlagen mittels nach dem Stapeln hergestellte, durch die Innenlagen hindurch verlaufende Leitungen verbunden werden müssen, ergeben sich angesichts der ständig zunehmenden Feinheit der hergestellten Schaltungen immer grössere Ansprüche an die gegenseitige Positionierung der Innenlagen eines Multilayer-Paketes. In der Regel wird dieses hergestellt, indem seine unterste Innenlage in einer sogenannten Layup-Station anhand optischer Markierungen, etwa feine Kreise und/oder Kreuze (sogenannte Target), präzise positioniert, und dann festgehalten wird. Danach werden ein oder mehrere, der Isolierung und dem späteren Verpressen dienende, Prepregs daraufgelegt, gefolgt von der nächsten Innenlage. Diese wird mit Hilfe optischer und fallweise elektronischer Zentriermittel auf ähnliche Weise wie die vorhergehende exakt positioniert, danach werden wieder ein oder mehrere Prepreg aufgelegt, usw., bis ein vollständiges Multilayer-Paket vorliegt. Dessen Elemente werden dann, beispielsweise durch HitzeEinwirkung zwischen heizbaren Schweisstempel, durch Vernietung mit Hohlnieten, durch Verklebung mit Klebstoff, usw. zu einer stabilen Einheit verbunden. Diese Stabilisierung ist nötig um beim nachfolgenden Verpressen des Multilayer-Paketes zu einem Laminat Verschiebungen zu vermeiden, da sonst beim Schmelzen der Prepregs mit einem gewissen Verschwimmen der zusammengepressten Innenlagen gerechnet werden muss. Bei diesem Verfahren entstehen jedoch zwei wesentliche Probleme welche die exakte gegenseitige Ausrichtung der Innenlagen in Frage stellen. Erstens kann sich in der Layup-Station eine schon ausgerichtete Innenlage beim Drauflegen nachfolgender Prepregs und Innenlagen leicht verschieben. Wenn dies vermieden werden kann, muss zweitens ein einmal aufgestapeltes Multilayer-Paket ohne Verschwimmen seiner Lagen präzise zusammengehalten werden, bis es in einem weiteren, von der Layup-Station getrennten Gerät beispielsweise durch Vernieten, stabilisiert wird. Als Gegenmassnahmen wurden bisher unter anderem folgende zwei Verfahren angewandt.

Einerseits wurden in jede Innenlage nach Massgabe der darauf aufgetragenen Schaltung mindestens zwei sogenannte Registrierlöcher gebohrt oder gestanzt und in diese das ganze Paket durchdringende Zentrierstifte gesteckt um die Innenlagen zueinander auszurichten und bis zu ihrer gegenseitigen Stabilisierung festzuhalten. Nachteile dieser zusätzlichen Schritte sind einerseits eine durch das unvermeidliche Verlaufen des Bohrers beim Bohren, oder des Schnittspieles beim Stanzen, entstehende Toleranz, zu welcher diejenige beim Einfädeln des Zentrierstiftes hinzukommt und andererseits der zusätzliche maschinelle Aufwand. Zudem erreicht dieses Verfahren im Endergebnis die heute verlangte Präzision im gegenseitigen Ausrichten der Innenlagen nur knapp und mit grosser Mühe. Ausserdem verlangsamt und verteuert insbesondere das Bohren oder Stanzen sowie das Einfädeln und das nachmalige Entfernen der Zentrierstifte den Herstellungsprozess in unerwünschter Weise. Ein exaktes gegenseitiges Fixieren der ausgerichteten Innenlagen in der Layup-Station durch andere Mittel als Zentrierstifte, beispielsweise durch ein in der Layup-Station durchgeführtes Verkleben hat sich bisher als aufwendig und unwirtschaftlich erwiesen.

Da andererseits das endgültige Verpressen aller Lagen in einer von der Layup-Station getrennten, heizbaren Presse, und fallweise erst zu einem späteren Zeitpunkt geschieht, und weil auch dabei noch ein Lageversatz der Innenlagen auftreten kann, werden die Multilayerpakete - wie bereits erwähnt - nach dem Layup, aber vor ihrem endgültigen Verpressen stabilisiert, beispielsweise indem sie ihrem Rand entlang vernietet, verschweisst oder verklebt werden. Aus Gründen der Konstruktion muss dies in einem von der Layup getrennten Gerät geschehen, wodurch die zusätzliche Aufgabe entsteht, das Multilayer-Paket zwecks Vernietung, Verschweissung oder Verklebung ohne Lageversatz von der Layup-Station zum Stabilisierungsgerät zu befördern. Hierfür wird das in der Layup-Station liegende Paket zwischen den zwei Flächen einer Transportzange gepresst und so zum Stabilisierungsgerät befördert, was einen zusätzlichen maschinellen Aufwand erfordert wenn dabei jegliches Verschwimmen der Innenlagen vermieden werden soll.

Die Erfindung löst obige Probleme gleichzeitig und in wirtschaftlich günstiger Weise. Hierzu ist sie wie in den Hauptansprüchen beschrieben, definiert. Dies gestattet es, in der Layup-Station selbst äusserst schnell eine Fixierung jeder Innenlage auf den darunterliegenden zu erreichen. Dies geschieht so exakt und zuverlässig, dass es genügt, um einen Lageversatz auch dann zu verhindern, wenn das Paket ohne weitere gegenseitige Immobilisierung der Innenlagen aus der Layup-Station entnommen und bis zu einer Stabilisierung, beispielsweise durch Vernieten, transportiert und fallweise zwischengelagert wird. In einer bevorzugten Ausgührung der Erfindung erfolgt das endgültige Verpressen des Multilayer-Paketes ohne vorhergehende Stabilisierung durch Vernieten oder dergleichen, was einen Verfahrensschritt erspart

Im Folgenden soll die Erfindung anhand der Beschreibung von Ausführungsbeispielen und anhand der Zeichnungen näher erläutert werden. Es zeigt:
Figur 1 einen schematischen Grundriss einer Layupline in welcher die Erfindung benützt wird,
Figur 2 eine schematischen, teilweisen Schnitt eines erfindungsgemässen Stanzwerkzeuges,
Figuren 3, 4 ein durch Prägestanzung gebildetes Zungenpaar,
Figuren 5, 6 ein Präge-Stanzwerkzeug und den zugehörigen Auswerfer,
Figur 7 einen perspektivischen, teilweisen Schnitt durch Werkzeug und Werkstück beim Prägestanzen, und
Figur 8 perspektivische Teilansichten der Ober- und Unterseite eines prägegestanzten Plättchens.

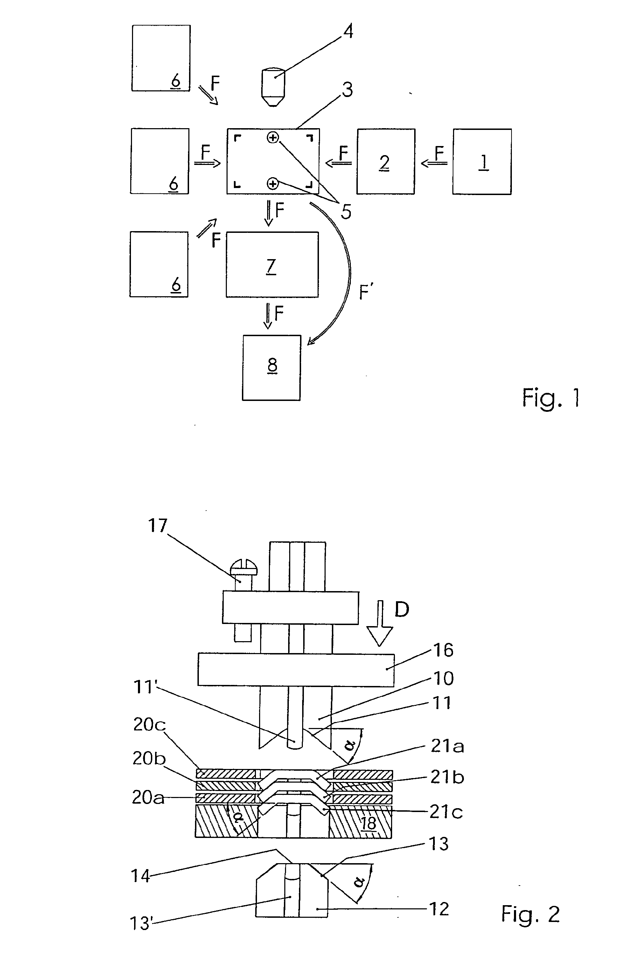

Figur 1 zeigt ein Schema einer erfindungsgemässen sogenannten Layup-Linie, d.h. einer Anlage zur automatisierten Herstellung von Multilayer-Paketen, ausgehend von einzelnen Innenlagen die unter Dazwischenlegen von Prepregs aufeinander gelegt, aneinander fixiert und schliesslich in gegenseitig äusserst exakter Ausrichtung zu einem Multilayer-Paket verpresst werden.

Es bezeichnet 1 eine Dispenser-Einheit welche die Innenlagen von einem (nicht gezeigten) handelsüblichen Kassettenwagen einzeln an ein Vorzentrierungsgerät 2 übergibt in welchem die Plättchen vorzentriert werden. Hier und im folgenden stellen mit F bezeichnete DoppelPfeile bekannte Förderanlagen oder Roboter für den Transport von Teilen von einer Arbeitsstation zur nächsten dar. Eine Vorzentrierung ist in der Regel nötig weil die nachfolgende, im Bereich von Tausendstel-mm arbeitende Zentriervorrichtung naturgemäss nur einen beschränkten Aktionsradius besitzt. Vom Vorzentrierungsgerät 2 werden die Innenlagen einzeln zur Layup-Station 3 befördert, und dort auf einen eventuell vorhandenen, unbeweglichen Stapel von schon zentrierten Innenlagen und Prepregs abgelegt. Mittels nicht gezeigter Mechanismen die durch eine in 4 angedeuteten optischen Zentrier-Einrichtung gesteuert werden, wird die jeweils zuoberst liegende Innenlage automatisch zentriert. Als Zentrierungsmarken dienen in der Regel mehrere auf der Innenlage aufgetragene Fadenkreuze oder ähnliche, als Target bezeichnete Marken 5 die in bestimmten Stellungen bezüglich der aufgetragenen Schaltung auf den Innenlagen angebracht sind. Wenn eine Innenlage zentriert ist, fahren ein oder mehrere Stempel - in der Regel vier mit schrägen Schnittflächen versehene Stempel - von oben so weit in die Innenlage, dass ein im Folgenden als Prägestanzung bezeichnetes Ausstanzen entsteht. Dabei werden eine oder mehrere Zungen ausgeschnitten und aus der Ebene der Innenlage nach unten herausgebogen, ohne an ihrer Wurzel abgetrennt zu werden, so dass sie einstückig mit ihrer Innenlage bleiben. Dies ist am besten aus den Figuren 2, 3 und 7, 8 ersichtlich, und wird weiter unten im einzelnen beschrieben. Dann werden aus dem Prepreg-Dispenser 6, welcher Prepregs verschiedener Typen enthält, ein oder mehrere Prepregs entnommen, längs der Förderwege F zur Layup-Station 3 gebracht, und auf die zuletzt präge-gestanzte Innenlage gelegt.

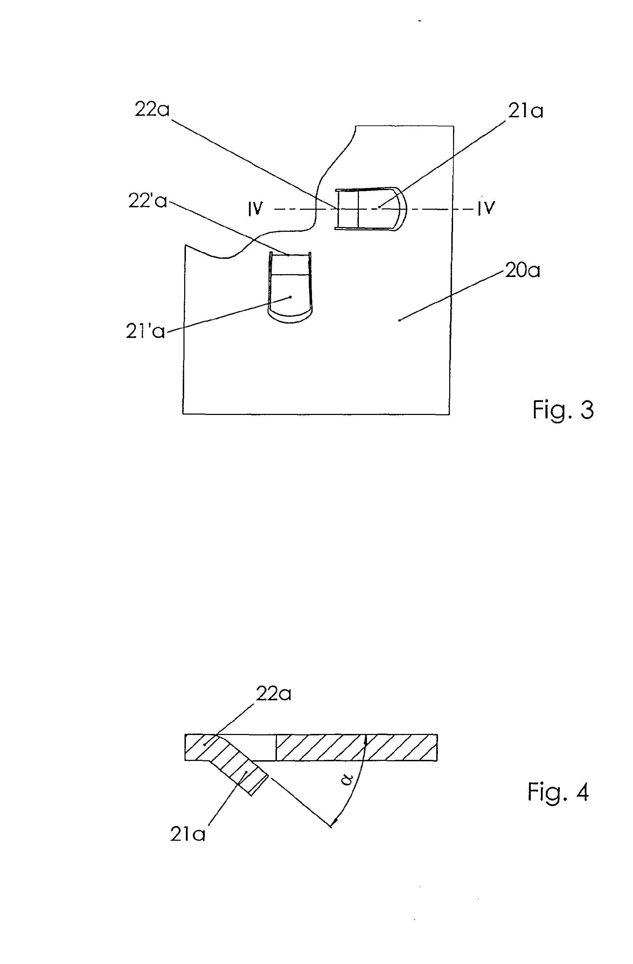

Sofern eine zu stanzende Innenlage nicht die unterste des Stapels ist, presst die Präge-Stanzung ihre Zungen in die Durchbrüche, welche die vorangehenden Präge-Stanzungen in einer oder mehreren darunterliegenden Innenlagen ausgespart haben. Dadurch wird die zuletzt aufgelegte Innenlage fixiert, und es werden aufeinanderfolgende Innenlagen gegenseitig verschränkt. Wenn die Längsachsen von mindestens zwei zu verschiedenen Präge-Stanzungen gehörigen Zungen verschieden orientiert sind, bewirkt diese Verschränkung, dass die betreffenden Innenlagen parallel zu ihrer Hauptebene formschlüssig verbunden sind. Zudem bewirkt die Pressung der Zungen in die Durchbrüche darunterliegender Plättchen eine gewisse kraftschlüssige Verbindung zwischen allen Plättchen des Stapels, senkrecht zu deren einander parallelen Hauptebenen. Um diese Verbindung zu verbessern können sich die Zungen von ihrer Wurzel zu ihrem freien Ende hin geringfügig verbreitern, d.h. ihre Ränder in Richtung ihres freien Endes um einige Grad divergieren, wie aus Fig. 3 ersichtlich. Die formschlüssige Verbindung der Plättchen sichert ihre gegenseitige Zentrierung aufs Genaueste solange das Paket nicht auseinandergerissen wird. Gleichzeitig erleichtert die kraftschlüssige Verbindung seine Manipulation wesentlich, indem sie die Plättchen zusammenhält solange man nicht auf verschiedene Plättchen verhältnismässig grosse, zu ihren Hauptebenen senkrechte und entgegengesetzte Kräfte ausübt. Demzufolge können die Pakete nach dem Präge-Stanzen ihres obersten Plättchens ohne besondere Vorsichtsmassnahmen von der Layup-Station 3 zu einem Stabilisierungs-Gerät 7 gebracht werden, wo das Paket am Rand vernietet wird. Danach gelangt es, fallweise nach einer nicht gezeigten Zwischenlagerung, zur heizbaren Presse 8, wo es in bekannter Weise endgültig zu einem Laminat verpresst wird. Wenn sich das Plättchenmaterial dafür eignet kann jedoch das nur durch die Präge-Stanzungen zusammengehaltene Paket unter Umgehung des Stabilisierungs-Prozesses direkt von der Layup-Station 3 zur heizbaren Presse 8 gebracht werden, wie durch den Doppel-Pfeil F' angedeutet. Es ist auch hier ein (nicht gezeigtes) Zwischenlagern möglich, was die Organisation des Fabrikationsprozesses unter Umständen wesentlich vereinfacht.

Da beim Stapeln in der Layup-Station jede Innenlage, nachdem sie zentriert ist und vor dem Auflegen der nächsten Platte - in der Regel ein Prepreg - gestanzt, und somit parallel zu ihrer Hauptebene formschlüssig auf einer eventuell darunterliegenden Innenlage fixiert wird, kann sie beim Auflegen darauffolgender Prepregs und/oder Innenlagen nicht mehr verrutschen. Dadurch entsteht ohne zusätzlichen Zeitaufwand ein deutlicher Präzisions-Gewinn beim Aufbau des Stapels.

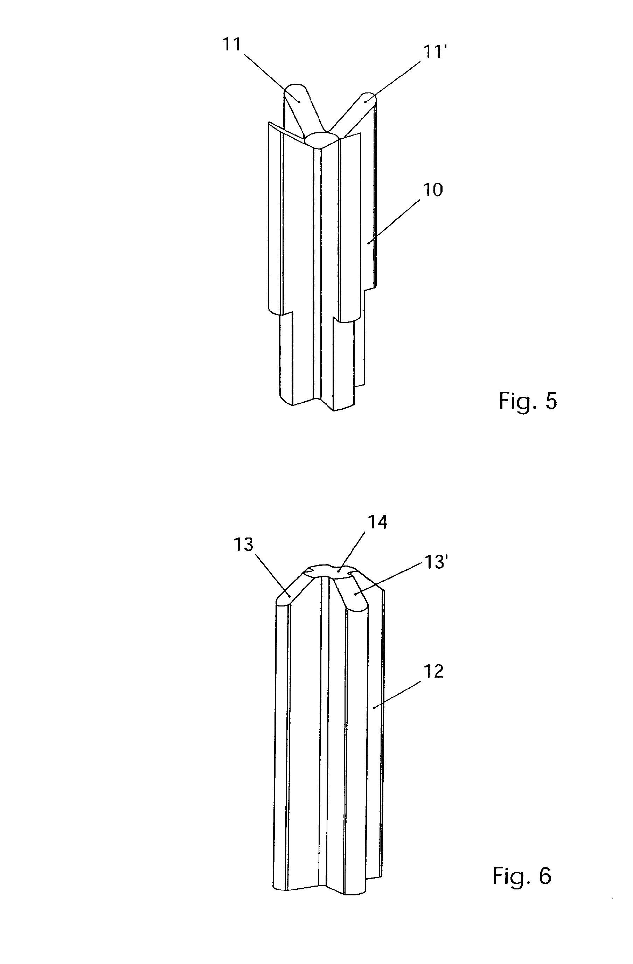

Die Figur 2 zeigt schematisch einen teilweisen Schnitt durch mehrere stanzgeprägte Zungen 21a, 21b, 21c, sowie Seitenansichten des verwendeten Stanzstempels 10 und des mit diesem fluchtenden Auswerf-Werkzeuges 12. Es sei hier bemerkt, dass die Beschränkung auf nur drei Platten der Klarheit halber geschieht, dem Fachmann aber bewusst ist, dass in der Regel eine viel grössere Anzahl Plättchen aufeinandergeschichtet wird. Der Stempel 10 und der Auswerfer 12 sind auf übliche Weise geführt, wobei der Klarheit halber diese Führungen ausgelassen wurden und nur die zum Stempel komplementäre Matrize 18, in welcher der Auswerfer läuft, andeutungsweise gezeigt ist. Die Formen des Stempels 10 und des Auswerfers 12 sind in den Figuren 5 und 6 perspektivisch veranschaulicht. Die Werkzeuge besitzen einen kreuz-förmigen Querschnitt mit zwei senkrecht aufeinander stehenden Armen, um zueinander rechtwinklig orientierte Zungen zu erzeugen. Beide Arme weisen komplementär geneigte Arbeitsflächen 11, 11'; 13, 13' auf, die einen Winkel α von etwa 25° mit den Hauptebenen der Platten 20a, 20b, 20c bilden. Der Auswerfer 12 besitzt zudem dort wo sich seine Arbeitsflächen kreuzen eine parallel zu den Hauptebenen ausgerichtete Druckfläche 14 welche beim Auswerfen des Paketes nach oben gegen einen nicht ausgeschnittenen Teil der untersten Platte drückt, um die durch das Prägestanzen abgebogenen Zungen nicht zu verformen. Des weiteren durchdringt der Stempel 10 eine Andruckplatte 16 die bei jedem Stanzvorgang mittels durch einen Pfeil D angedeutete Druckmittel gegen das oberste zu stanzende Plättchen gepresst wird. Ein nur schematisch gezeichneter, einstellbarer Anschlag 17 der sich mit dem Stempel 10 bewegt begrenzt die Eindringtiefe des Stempels 10 und sorgt dafür, dass er höchstens mit seiner schrägen Arbeitsfläche 11, 11' in die zu stanzende Plättchen eindringt, um die oberste gestanzte Zunge nicht von ihrem Plättchen zu trennen. Es ist dem Fachmann klar, dass der Anschlag 17 symbolisch zu verstehen ist, und seine Funktion in der Praxis durch bekannte elektrische oder mechanische Vorrichtungen erfüllt wird.

Die Figuren 3 und 4 veranschaulichen die Form eines durch Stanzprägung gebildetes Zungenpaares 21a, 21'a das in einem Winkel α aus der Platte 20a herausgebogen ist und nur noch an den Stellen 22a, 22'a mit dieser zusammenhängt. Beide Zungen verbreitern sich ein wenig in Richtung ihres freien Endes, um nach ihrem Eingriff in Öffnungen eines oder mehrerer anderer Plättchen den Kraftschluss senkrecht zu den Plättchen zu verstärken. Der Winkel dieser Verbreiterung hängt vom Material der Plättchen ab. In der Fig. 3 sind die Projektionen der Abstände der Zungenränder vom Plättchen der Anschaulichkeit halber vergrössert dargestellt. Es ist zu bemerken, dass diese Abstände so gering sein werden wie es ein sauberer Schnitt bewirkt.

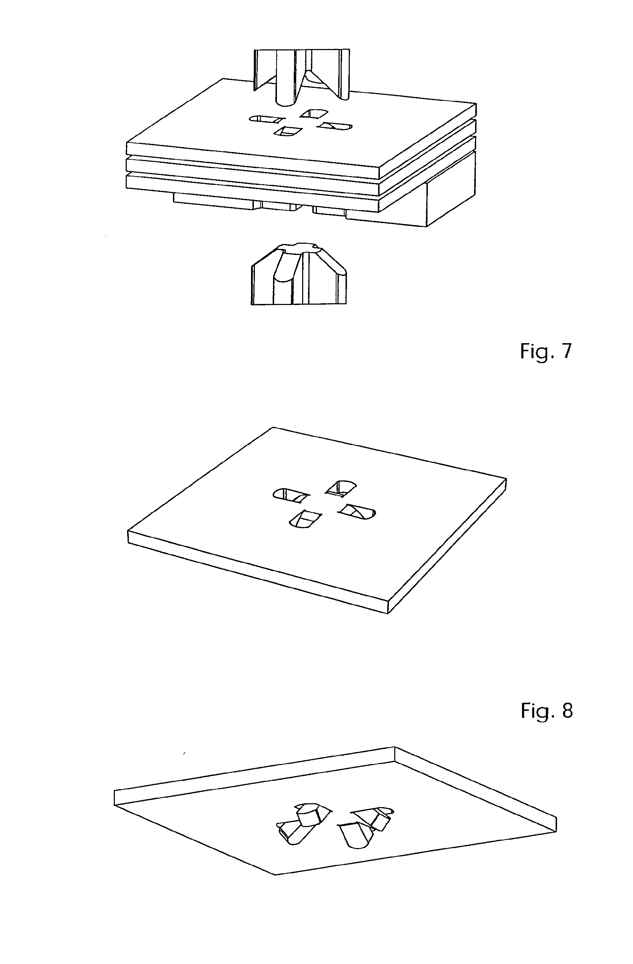

Die Figur 7 veranschaulicht eine bevorzugte Ausführungsform der Werkzeuge, bei welcher der Stempel und der Auswerfer einen kreuzförmigen Querschnitt aufweisen. Es können aber auch Stempel mit einem v-förmigen Querschnitt oder mit anderen Querschnittsformen verwendet werden. Der besseren Anschauung halber ist in Figur 7 die Matrize im Schnitt gezeigt, während Figur 8 eine perspektivische Ansicht von oben und von unten auf ein einzelnes mit dem Werkzeug der Fig. 7 präge-gestanztes Plättchen zeigt.

## Patentansprüche

1. Verfahren für die Herstellung eines Multilayer-Paketes von Schaltungen, **dadurch gekennzeichnet, dass** deren parallel zur Hauptebene des Paketes ausgerichtete Innenlagen gegenseitig fixiert werden, indem durch Präge-Stanzen der die einzelnen Lagen des Paketes bildenden Plättchen mindestens eine Zunge aus der Ebene jedes Plättchens herausgebogen wird, wobei die nicht zum untersten Plättchen gehörigen Zungen je in mindestens eine, durch Herausbiegen einer Zunge aus dem darunterliegenden Plättchen geschaffene Öffnung hineinragen, um mindestens zwischen je zwei aufeinanderfolgenden Plättchen eine parallel zu ihren Hauptebenen formschlüssige Verbindung zu schaffen.

2. Verfahren nach Anspruch 1, **dadurch gekennzeichnet, dass** alle senkrecht zur Hauptebene des Paketes fluchtenden Zungen eines Paketes nacheinander unter Benützung desselben Stempels und derselben Matrize herausgebogen werden, wobei für das Präge-Stanzen aller Plättchen ausser der untersten die Oberfläche des unmittelbar darunterliegenden Plättchens als Matrizenoberfläche wirkt.

3. Verfahren nach einem der vorangehenden Ansprüche, **dadurch gekennzeichnet, dass** mindestens eine Zunge jeder nicht zuunterst liegenden Innenlage in die durch Herausbiegen einer Zunge aus der nächstunteren Innenlage geschaffene Öffnung hineingebogen wird.

4. Verfahren nach einem der vorangehenden Ansprüche, **dadurch gekennzeichnet, dass** das Paket nach dem Prägestanzen all seiner Lagen durch einen mit dem für das Prägestanzen benützten Stempel fluchtenden Auswerfer ausgeworfen wird, dessen Querschnitt im wesentlichen gleich demjenigen des Stempels ist und dessen Arbeitsflächen im wesentlichen komplementär zu den entsprechenden Schnittflächen des Stempels geformt sind.

5. Verfahren nach einem der vorangehenden Ansprüche, **dadurch gekennzeichnet, dass** das durch die herausgebogenen Zungen zusammengehaltene Paket ohne vorangehendes Punktschweissen oder Vernieten in einer heizbaren Presse zu einem Laminat verpresst wird.

6. Vorrichtung zur Durchführung des Verfahrens nach einem der vorangehenden Ansprüche, **gekennzeichnet durch** Mittel, um Plättchen nacheinander auf einer Matrizenfläche zu stapeln, um mindestens jede eine Innenlage bildendes Plättchen zu zentrieren, und um danach **durch** Prägestanzung mindestens eine Zunge aus der Ebene dieses Plättchen herauszubiegen, sowie **durch** Mittel, um den Hub des oder der Stempel mit zunehmender Zahl von bereits gestanzten Plättchen zunehmend zu begrenzen.

7. Vorrichtung nach Anspruch 6, **dadurch gekennzeichnet, dass** mindestens ein Stempel einen v-förmigen Querschnitt hat, dessen Arme einen Winkel von mindestens 30° einschliessen.

8. Vorrichtung nach Anspruch 7, **dadurch gekennzeichnet, dass** sie vier in den Ecken eines Rechteckes liegende Stempel aufweist, und dass die Spitzen der v-förmigen Querschnitte der Stempel paarweise in entgegengesetzte Richtungen zeigen.

9. Vorrichtung nach Anspruch 6, **dadurch gekennzeichnet, dass** mindestens ein Stempel einen kreuzförmigen Querschnitt hat, dessen aufeinanderfolgende Arme einen kleinsten Winkel von mindestens 30° einschliessen.

10. Vorrichtung nach einem der Ansprüche 7 bis 9, **dadurch gekennzeichnet, dass** die Arme im Querschnitt eine im wesentlichen konstante Breite aufweisen.

11. Verfahren nach einem der Ansprüche 7 bis 9, **dadurch gekennzeichnet, dass** die Arme im Querschnitt in Richtung ihres freien Endes eine um bis zu 8° divergierende Breite aufweisen.

12. Vorrichtung nach einem der Ansprüche 6 bis 11, **dadurch gekennzeichnet, dass** die Arbeitsflächen mindestens eines Stempels um mindestens 10° gegenüber den Hauptebenen der Plättchen geneigt sind.

13. Vorrichtung nach einem der Ansprüche 6 bis 12, zur Durchführung des Verfahrens nach Anspruch 4, **dadurch gekennzeichnet, dass** sie mindestens einen mit einem zugehörigen Stempel fluchtenden Auswerfer aufweist dessen Querschnitt im wesentlichen gleich dem dieses Stempels ist und der mindestens eine Druckfläche aufweist die in komplementärer Weise zu einer Arbeitsfläche des Stempels geneigt ist.

14. Vorrichtung nach Anspruch 13, **dadurch gekennzeichnet, dass** der Auswerfer eine zur Hauptebene der Plättchen parallele Druckfläche aufweist, die beim Auswerfen gegen einen nicht ausgestanzten Bereich des zuunterst liegenden Plättchens drückt.
